(19) Europäisches Patentamt
European Patent Office
Office européen des brevets

(11) **EP 4 607 693 A1**

(12) **EUROPEAN PATENT APPLICATION**
published in accordance with Art. 153(4) EPC

(43) Date of publication:
**27.08.2025 Bulletin 2025/35**

(21) Application number: **23897198.0**

(22) Date of filing: **11.09.2023**

(51) International Patent Classification (IPC):
**H01P 1/18** (2006.01)    **H03H 7/18** (2006.01)
**H03H 11/16** (2006.01)

(52) Cooperative Patent Classification (CPC):
**H01P 1/18; H03H 7/18; H03H 11/16**

(86) International application number:
**PCT/JP2023/033011**

(87) International publication number:
**WO 2024/116539 (06.06.2024 Gazette 2024/23)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **02.12.2022 JP 2022193673**

(71) Applicant: **Murata Manufacturing Co., Ltd.
Nagaokakyo-shi, Kyoto 617-8555 (JP)**

(72) Inventors:
• **YANG Bo
Kyoto-shi, Kyoto 606-8501 (JP)**

• **SHINOHARA Naoki
Kyoto-shi, Kyoto 606-8501 (JP)**
• **KAJIWARA Tsuyoshi
Kyoto-shi, Kyoto 606-8501 (JP)**
• **OKADA Takayuki
Nagaokakyo-shi, Kyoto 617-8555 (JP)**
• **MIYASAKO Takaaki
Nagaokakyo-shi, Kyoto 617-8555 (JP)**

(74) Representative: **Zimmermann, Tankred Klaus et al
Schoppe, Zimmermann, Stöckeler
Zinkler, Schenk & Partner mbB
Patentanwälte
Radlkoferstrasse 2
81373 München (DE)**

(54) **RF PHASE SHIFTER**

(57)  Provided is an RF phase shifter capable of highly accurate phase control. An RF phase shifter 100 comprises: a phase shifter 110 that receives an input RF signal, generates an output RF signal in which the phase of the input RF signal is changed to a set phase in accordance with a control voltage, and outputs the output RF signal; a phase comparator 120 that generates a phase difference voltage according to a phase difference between the input RF signal and the output RF signal; and an arithmetic processing unit 130 that generates a control voltage according to a voltage difference between the phase difference voltage and a reference voltage according to the set phase.

FIG. 1

EP 4 607 693 A1

**Description**

TECHNICAL FIELD

The present invention relates to an RF phase shifter.

BACKGROUND ART

An RF (high frequency) phase shifter that generates an output RF signal in which the phase of an input RF signal is changed to a set phase is known (for example, see Patent Document 1).

Citation List

Patent Document

Patent Document 1: Japanese Unexamined Patent Application, Publication No. H09-074325

DISCLOSURE OF THE INVENTION

Problems to be Solved by the Invention

In such an RF phase shifter, highly accurate phase control is demanded. As a method of improving the accuracy of phase control of the RF phase shifter, fine phase shift control is considered. However, in a conventional RF phase shifter, there is an error of several degrees between the set phase and the output phase, and the accuracy of phase control is low. Therefore, the true value of the output phase is unknown, and it is difficult to ensure the accuracy of the phase control.
Therefore, an object of the present invention is to provide an RF phase shifter capable of highly accurate phase control.

Means for Solving the Problems

An RF phase shifter according to the present invention includes: a phase shifter configured to receive an input RF signal, generate an output RF signal in which a phase of the input RF signal is changed to a set phase according to a control voltage, and output the output RF signal; a phase detector configured to generate a phase difference voltage according to a phase difference between the input RF signal and the output RF signal; and a processing unit configured to generate the control voltage according to a voltage difference between the phase difference voltage and a reference voltage according to the set phase.
Another RF phase shifter according to the present invention includes: a digital phase shifter configured to receive an input RF signal, generate an output RF signal in which a phase of the input RF signal is changed to a set phase according to a digital control signal, and output the output RF signal; a phase detector configured to generate a phase difference voltage according to a phase difference between the input RF signal and the output RF signal; and a processing unit configured to generate the digital control signal according to a voltage difference between the phase difference voltage and a reference voltage according to the set phase.

Effects of the Invention

According to the present invention, highly accurate phase control is possible in the RF phase shifter.

BRIEF DESCRIPTION OF THE DRAWINGS

FIG. 1 is a schematic diagram showing an RF phase shifter according to the present embodiment;
FIG. 2 is a circuit diagram showing an RF phase shifter (analog type) according to a first embodiment;
FIG. 3 is a circuit diagram showing an RF phase shifter (digital type) according to a second embodiment;
FIG. 4 is a circuit diagram showing an example of a phase shifter (digital type) in the RF phase shifter shown in FIG. 3;
FIG. 5 is a circuit diagram showing another example of the phase shifter (digital type) in the RF phase shifter shown in FIG. 3;
FIG. 6 is a circuit diagram showing an example of a variable reactance element (digital type) in the phase shifter shown in FIG. 4 or 5;
FIG. 7 is a circuit diagram showing another example of the variable reactance element (digital type) in the phase shifter shown in FIG. 4 or 5; and
FIG. 8 is a circuit diagram showing another example of the variable reactance element (digital type) in the phase shifter shown in FIG. 4 or 5.

PREFERRED MODE FOR CARRYING OUT THE INVENTION

Hereinafter, an exemplary embodiment of the present invention will be described with reference to the accompanying drawings. In the drawings, the same or corresponding portions are denoted by the same reference numerals.

[First Embodiment]

(RF Phase Shifter)

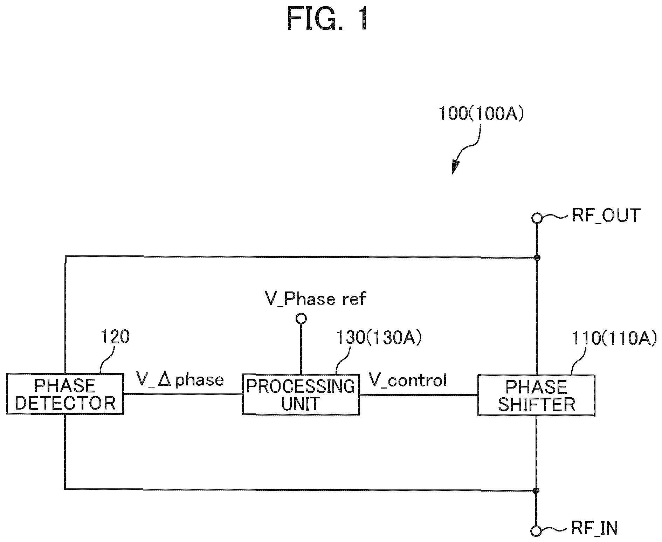

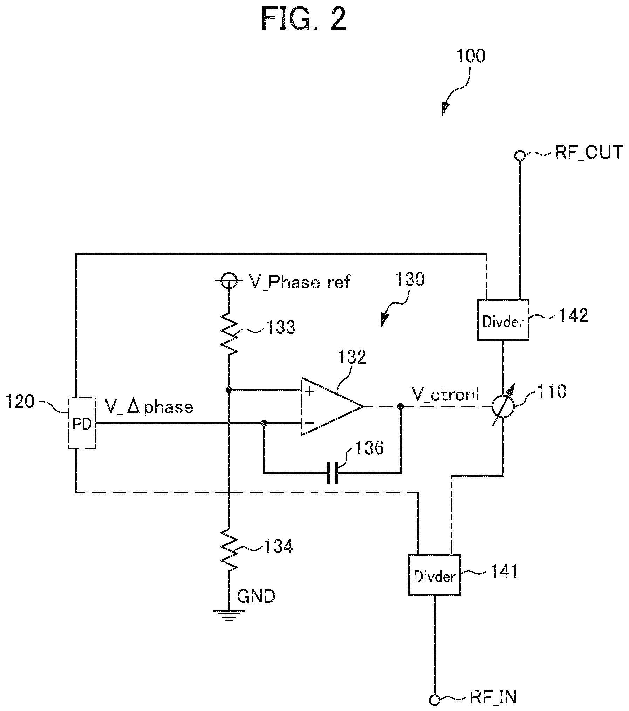

FIG. 1 is a schematic diagram showing an RF phase shifter according to the present embodiment, and FIG. 2 is a circuit diagram showing an RF phase shifter according to a first embodiment. An RF phase shifter 100 shown in FIGS. 1 and 2 includes an analog phase shifter 110, a phase detector 120, and an analog processing unit 130. As shown in FIG. 2, the RF phase shifter 100 may include dividers 141 and 142.
The divider 141 divides the RF signal input to the input terminal RF_IN of the RF phase shifter 100 into an input RF signal of the phase shifter 110 and an input RF signal for the phase detector 120.
The divider 142 divides the output RF signal of the phase shifter 110 into an output RF signal for the phase detector 120 and an RF signal output from the output terminal RF_OUT of the RF phase shifter 100.
The phase shifter 110 is an analog phase shifter. The phase shifter 110 receives an input RF signal, generates an output RF signal in which the phase of the input RF signal is changed to a set phase according to a control voltage, and outputs the output RF signal.
The phase detector 120 is a highly accurate phase detector. The phase detector 120 compares the phase of the input RF signal with the phase of the output RF signal, and generates a voltage having a voltage value according to the phase difference. This voltage is defined as a phase difference voltage.
The processing unit 130 is an analog processing unit and includes an operational amplifier 132. One input of the operational amplifier 132 is connected to the output of the phase detector 120. The other input of the operational amplifier 132 is connected to an intermediate point between resistors 133 and 134 connected in series between the reference voltage line V_Phase ref and the ground line GND. The output of the operational amplifier 132 is feedback-connected to one input of the operational amplifier 132 via a capacitor 136 in series.
The phase difference voltage V_Δphase is input to one input of the operational amplifier 132. The reference voltage V_Phase ref, specifically, the reference voltage V_Phase ref divided by the resistors 133 and 134 is input to the other input of the operational amplifier 132. The reference voltage V_Phase ref is a voltage according to a set phase of the phase shifter 110, for example, a set phase of the output RF signal.
With such a configuration, the processing unit 130 generates a voltage according to a voltage difference between the phase difference voltage V_Δphase and the reference voltage V_Phase ref. Specifically, the processing unit 130 integrates the difference voltage between the phase difference voltage V_Δphase and the reference voltage V_Phase ref as shown in the following equation.

$$V\_control = \int (V\_\Delta phase - V\_Phase\ ref)dt$$

The processing unit 130 feeds back this voltage as the control voltage V_control to the phase shifter 110.
As described above, according to the RF phase shifter 100 of the first embodiment, the output phase and the input phase of the phase shifter 110 are compared with each other by the highly accurate phase detector 120, and the difference value between the phase difference and the set phase difference (V_Phase ref) is integrated and fed back to the phase shifter 110 to adjust the output phase to the set phase. This enables highly accurate phase control. Further, the output phase of the output RF signal can be stabilized for a long period of time.
In particular, since the processing unit 130 performs the integration process, highly accurate phase control is possible even when the frequency of the phase shift target signal becomes high, and the output phase of the output RF signal can be stabilized for a long period of time.

[Second Embodiment]

(RF Phase Shifter)

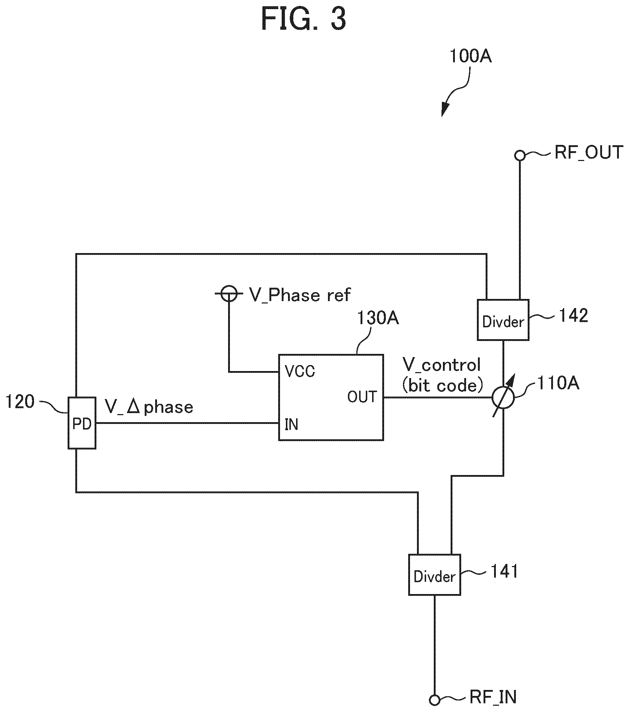

FIG. 1 is a schematic diagram showing an RF phase shifter according to the present embodiment, and FIG. 3 is a circuit diagram showing an RF phase shifter according to a second embodiment. An RF phase shifter 100A shown in FIGS. 1 and 3 differs from the RF phase shifter 100 of the first embodiment shown in FIGS. 1 and 2 in that a digital phase shifter 110A and a digital processing unit 130A are provided instead of the analog phase shifter 110 and the analog processing unit 130.

The phase shifter 110A is a digital phase shifter. The phase shifter 110A receives an input RF signal, generates an output RF signal in which the phase of the input RF signal is changed to a set phase according to a digital control signal, and outputs the output RF signal.

The processing unit 130A is a digital processing unit and includes a processor such a processing unit (PU), digital signal processor (DSP), or field-programmable gate array (FPGA). The functions of the processing unit 130A are realized by executing predetermined software (program) stored in the memory. The functions of the processing unit 130A may be realized by a combination of hardware and software, or may be realized only by hardware (electronic circuit).

One input of the processing unit 130A is connected to the output of the phase detector 120, and the other input of the processing unit 130A is connected to the reference voltage line V_Phase ref. The output of the processing unit 130A is connected to the phase shifter 110A.

The phase difference voltage V_Δphase is input to one input of the processing unit 130A. The reference voltage V_Phase ref is input to the other input of the processing unit 130A. The reference voltage V_Phase ref is a voltage according to a set phase of the phase shifter 110A, for example, a set phase of the output RF signal.

The processing unit 130A generates a signal according to a voltage difference between the phase difference voltage V_Δphase and the reference voltage V_Phase ref. Specifically, the processing unit 130A integrates the difference voltage between the phase difference voltage V_Δphase and the reference voltage V_Phase ref as shown in the following equation.

$$V\_control = \int (V\_\Delta phase - V\_Phase\ ref)dt$$

The processing unit 130A converts this voltage into a bit code, and feeds back the converted signal to the phase shifter 110A as a digital control signal V_control (bit code).

As described above, also in the RF phase shifter 100A of the second embodiment, the output phase and the input phase of the phase shifter 110A are compared with each other by the highly accurate phase detector 120, and the difference value between the phase difference and the set phase difference (V_Phase ref) is fed back to the phase shifter 110A, and the output phase is adjusted to the set phase. This enables highly accurate phase control. Further, the output phase of the output RF signal can be stabilized for a long period of time.

In particular, since the processing unit 130A performs the integration process, highly accurate phase control is possible even when the frequency of the phase shift target signal becomes high, and the output phase of the output RF signal can be stabilized for a long period of time.

(Digital Phase Shifter)

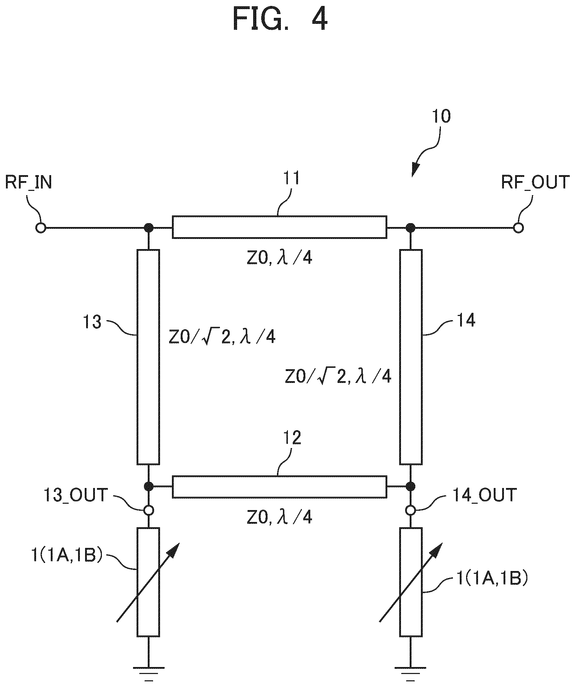

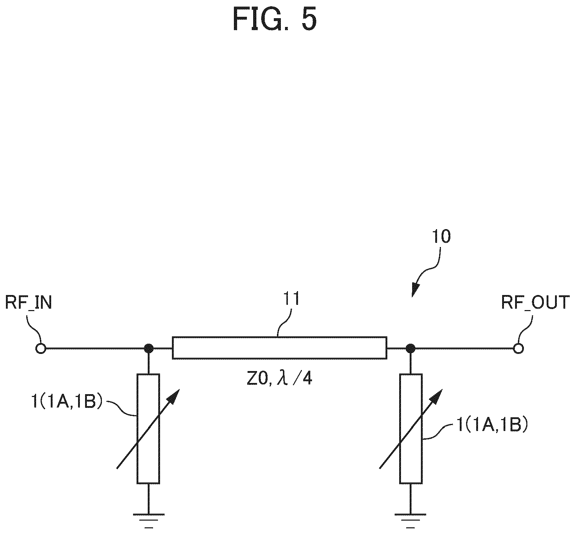

Hereinafter, an example of the digital phase shifter 110A shown in FIG. 3 will be described. FIG. 4 is a circuit diagram showing an example of the phase shifter according to the present embodiment, and FIG. 5 is a circuit diagram showing another example of the phase shifter according to the present embodiment. The phase shifter 10 shown in FIG. 4 or 5 can be used as the digital phase shifter 110A shown in FIG. 3.

The phase shifter 10 shown in FIG. 4 is a hybrid coupled high frequency (RF) phase shifter including 1/4 wavelength lines 11 and 12 having a characteristic impedance of Z0 and 1/4 wavelength lines 13 and 14 having a characteristic impedance of Z0/√2. The phase shifter 10 includes an input terminal RF_IN at one end of a line 11 and an output terminal RF_OUT at the other end of the line 11. The phase shifter 10 includes variable reactance elements 1 (1A, 1B) that respectively terminate an output terminal 13_OUT on the line 13 side and an output terminal 14_OUT on the line 14 side. Details of the variable reactance elements 1 (1A, 1B) will be described later.

In the phase shifter 10, a RF signal input from the input terminal RF_IN are distributed by the hybrid coupled lines 11, 12, 13, and 14, and are transmitted to the output terminal 13_OUT on the line 13 side and the output terminal 14_OUT on the line 14 side. Since these output terminals 13_OUT and 14_OUT are terminated by the variable reactance elements 1 (1A, 1B), the signals transmitted to these output terminals undergo a phase change dependent on the amount of reactance of the variable reactance elements 1 (1A, 1B) and are reflected. The signals reflected by the output terminals 13_OUT and 14_OUT are recombined by the hybrid coupled lines 11, 12, 13, and 14, and output from the output terminal RF_OUT. At this time, the output signals undergo a phase change dependent on the amount of reactance of the variable reactance elements 1 (1A, 1B), and the phase shifter 10 operates as a phase shifter by changing the amount of reactance of the variable reactance elements.

Although FIG. 4 shows an example in which the variable reactance elements 1 (1A, 1B) are applied to the hybrid coupled phase shifter 10, as shown in FIG. 5, the variable reactance elements 1 (1A, 1B) may be applied to a loaded line phase shifter 10 including a 1/4 wavelength line 11 having a characteristic impedance of Z0.

As described above, according to the high-frequency phase shifter to which the digital variable reactance elements described later are applied, since the reactance can be widely varied in both capacitive and inductive characteristics, it is possible to realize a high-frequency (RF) phase shifter having a low loss and a large phase shift width.

(Digital Variable Reactance Element)

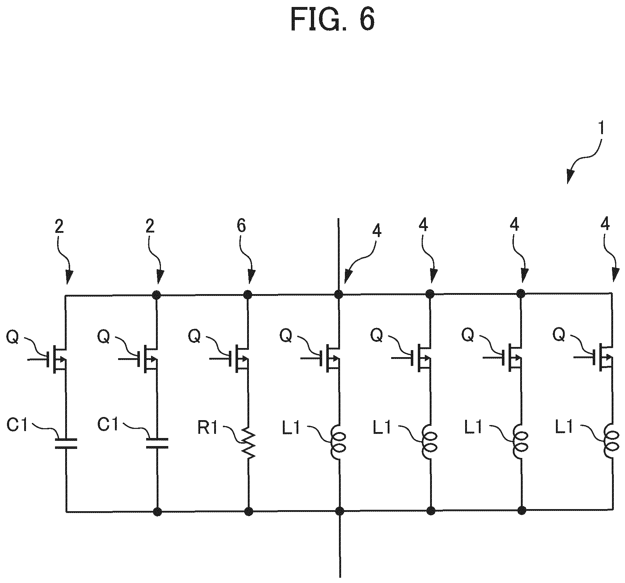

Hereinafter, examples of the variable reactance elements shown in FIGS. 4 and 5 will be described. FIG. 6 is a circuit diagram showing a digital variable reactance element according to the present embodiment. As shown in FIG. 6, a digital variable reactance element 1 digitally varies reactance. The digital variable reactance element 1 includes a plurality of digital capacitors 2 and a plurality of digital inductors 4. The digital variable reactance element 1 may include a digital resistor 6. In the digital variable reactance element 1, the plurality of digital capacitors 2, the plurality of digital inductors 4, and the digital resistor 6 are connected in parallel.

The digital capacitor 2 includes a capacitor C1 and a digital switch (first digital switch) Q connected in series. As the digital switch Q, a switching element such as a field effect transistor (FET) is used, although it is not limited. The digital switch Q can be switched between two states: an on state and an off state. This allows the digital capacitor 2 to be switched between two values: a first value, which is the capacitance of the capacitor C1 (the digital switch Q is in the on state), and a second value, which is a capacitance of 0 (the digital switch Q is in the off state). That is, the digital capacitor 2 allows the capacitance to be digitally switched.

The digital inductor 4 includes an inductor L1 and a digital switch (second digital switch) Q connected in series. As the digital switch Q, a switching element such as a field effect transistor (FET) is used, although it is not limited. The digital switch Q can be switched between two states: an on state and an off state. This allows the digital inductor 4 to be switched between two values: a first value, which is the inductance of the inductor L1 (the digital switch Q is in the on state), and a second value, which is an inductance of 0 (the digital switch Q is in the off state). That is, the digital inductor 4 allows the inductance to be digitally switched.

The digital resistor 6 includes a resistor R1 and a digital switch Q connected in series. As the digital switch Q, a switching element such as a field effect transistor (FET) is used, although it is not limited. The digital switch Q can be switched between two states: an on state and an off state. This allows the digital resistor 6 to be switched between two values: a first value, which is the resistance value of the resistor R1 (the digital switch Q is in the on state), and a second value, which is a resistance value of 0 (the digital switch Q is in the off state). That is, the digital resistor 6 allows the resistance value to be digitally switched.

Thus, the variable reactance element 1 can digitally vary the reactance by switching each digital switch Q between an on state and an off state. Further, the variable reactance element 1 can digitally vary the impedance, particularly the impedance with respect to the RF signal (high-frequency signal) by switching each digital switch Q between an on state and an off state.

According to the digital variable reactance element 1, the reactance of a plurality of capacitors C1 and a plurality of inductors L1 is digitally varied by the control with the digital switch Q. Further, according to the digital variable reactance element 1, the impedance of the plurality of capacitors C1, the plurality of inductors L1, and the resistor R1 is digitally varied by the control with the digital switch Q.

In addition, not only the capacitance but also the inductance can be varied, and the reactance can be widely varied in capacitive ($1/2\pi fc$) and inductive ($2\pi fL$) characteristics. Therefore, the variable width of the reactance ($1/2\pi fc + 2\pi fL$) can be widened.

In addition, a plurality of variable capacitors or a plurality of variable inductors are not used, and the control signals of the plurality of variable capacitors or the plurality of variable inductors are not complicated.

Further, it is possible to realize a high frequency (RF) phase shifter having a low loss and a large phase shift width.

In the embodiment described above, the variable reactance element 1 has been exemplified in which each digital capacitor 2 includes the capacitor C1 and the digital switch Q connected in series, each digital inductor 4 includes an inductor and a digital switch connected in series or in parallel, and the plurality of digital capacitors 2 and the plurality of digital inductors 4 are connected in parallel. However, the present invention is not limited thereto, and is applicable to various variable reactance elements in which each digital capacitor includes a capacitor and a digital switch connected in series or in parallel, each digital inductor includes an inductor and a digital switch connected in series or in parallel, and a plurality of digital capacitors and a plurality of digital inductors are connected in series or in parallel. For example, Modifications 1 and 2 of the present embodiment will be exemplified below.

(Digital Variable Reactance Element of Modification 1)

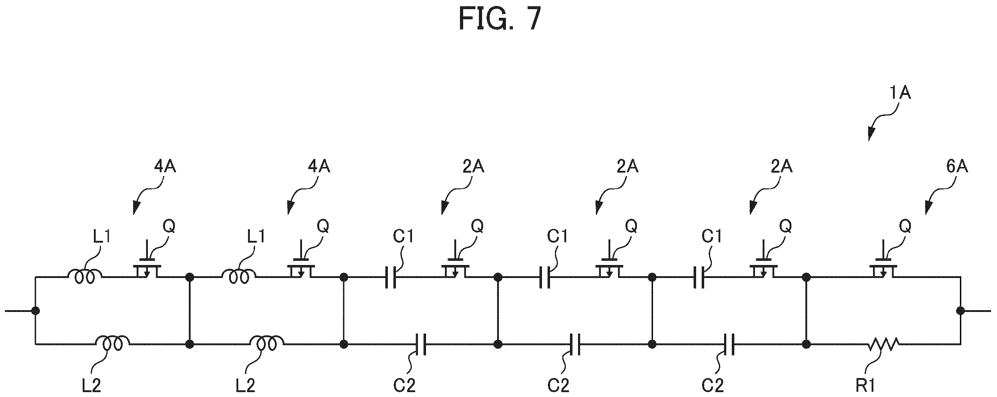

FIG. 7 is a circuit diagram showing a digital variable reactance element according to Modification 1 of the present embodiment. As shown in FIG. 7, a digital variable reactance element 1A digitally varies reactance. The digital variable reactance element 1A includes a plurality of digital capacitors 2A and a plurality of digital inductors 4A. The digital variable reactance element 1A may include a digital resistor 6A. In the digital variable reactance element 1A, the plurality of digital capacitors 2A, the plurality of digital inductors 4A, and the digital resistor 6A are connected in series.

The digital capacitor 2A includes a capacitor C1 and a digital switch (first digital switch) Q connected in series, and a capacitor C2 and the digital switch Q connected in parallel. Specifically, in the digital capacitor 2A, the series circuit of the capacitor C1 and the digital switch Q, and the capacitor C2, are connected in parallel. The digital switch Q is the same as described above. Thus, the digital capacitor 2A can be switched between two values: a first value, which is the combined capacitance of the capacitor C1 and the capacitor C2 (the digital switch Q is in the on state), and a second value, which is the capacitance of the capacitor C2 (the digital switch Q is in the off state). That is, the digital capacitor 2A allows the capacitance to be digitally switched.

The digital inductor 4A includes an inductor L1 and a digital switch (second digital switch) Q connected in series, and an inductor L2 and the digital switch Q connected in parallel. Specifically, in the digital inductor 4A, the series circuit of the inductor L1 and the digital switch Q, and the inductor L2, are connected in parallel. The digital switch Q is the same as described above. Thus, the digital inductor 4A can be switched between two values: a first value, which is the combined inductance of the inductor L1 and the inductor L2 (the digital switch Q is in the on state), and a second value, which is the inductance of the inductor L2 (the digital switch Q is in the off state). That is, the digital inductor 4A allows the inductance to be digitally switched.

The digital resistor 6A includes a resistor R1 and a digital switch Q connected in parallel. The digital switch Q is the same as described above. Thus, the digital resistor 6A can be switched between two values: a first value, which is a resistance value of 0 (the digital switch Q is in the on state), and a second value, which is the resistance value of the resistor R1 (the digital switch Q is in the off state). That is, the digital resistor 6A allows the resistance value to be digitally switched.

Thus, in the variable reactance element 1A, the reactance can be digitally switched by switching each digital switch Q between an on state and an off state. Further, in the variable reactance element 1A, the impedance, particularly the impedance with respect to the RF signal (high-frequency signal), can be digitally varied by switching each digital switch Q between an on state and an off state.

The digital variable reactance element 1A of modification 1 also has the same advantages as those of the digital variable reactance element 1 of the present embodiment described above.

(Digital Variable Reactance Element of Modification 2)

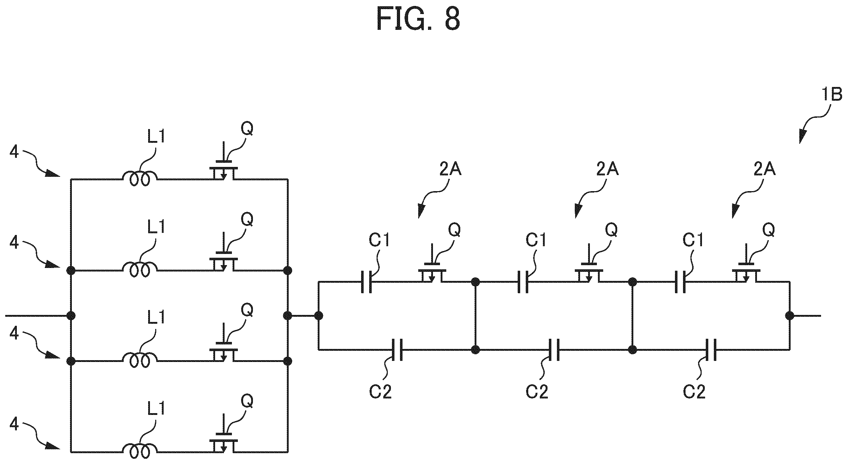

FIG. 8 is a circuit diagram showing a digital variable reactance element according to Modification 2 of the present embodiment. As shown in FIG. 8, a digital variable reactance element 1B digitally varies reactance. The digital variable reactance element 1B includes a plurality of the digital capacitors 2A and a plurality of the digital inductors 4. In the digital variable reactance element 1B, the plurality of the digital capacitors 2A are connected in series, the plurality of the digital inductors 4 are connected in parallel, and the series circuit of the digital capacitors 2A and the parallel circuit of the digital inductors 4 are connected in series.

Accordingly, the variable reactance element 1B can digitally vary the reactance by switching each digital switch Q between an on state and an off state. Further, the variable reactance element 1B can digitally vary the impedance, particularly the impedance with respect to the RF signal (high-frequency signal) by switching each digital switch Q between an on state and an off state.

The digital variable reactance element 1B of Modification 2 also has the same advantages as those of the digital variable reactance element 1 of the present embodiment described above.

Although the embodiments of the present invention have been described above, the present invention is not limited to the above-described embodiments, and various modifications and variations are possible. Further, the RF phase shifters of the above-described embodiments are applicable to technical fields such as phased array, radar, synthesizer, and communication.

EXPLANATION OF REFERENCE NUMERALS

1, 1A, 1B digital variable reactance element

2, 2A digital capacitor
4, 4A digital inductor
6, 6A digital resistor

C1, C2 capacitor
L1, L2 inductor
R1 resistor
Q digital switch
10, 110, 110A phase shifter
100,100A RF phase shifter
120 phase detector
130, 130A processing unit
132 operational amplifier
133, 134 resistor
136 capacitor
141, 142 divider

**Claims**

1.  An RF phase shifter comprising:

    a phase shifter configured to receive an input RF signal, generate an output RF signal in which a phase of the input RF signal is changed to a set phase according to a control voltage, and output the output RF signal;
    a phase detector configured to generate a phase difference voltage according to a phase difference between the input RF signal and the output RF signal; and
    a processing unit configured to generate the control voltage according to a voltage difference between the phase difference voltage and a reference voltage according to the set phase.

2.  An RF phase shifter comprising:

    a digital phase shifter configured to receive an input RF signal, generate an output RF signal in which a phase of the input RF signal is changed to a set phase according to a digital control signal, and output the output RF signal;
    a phase detector configured to generate a phase difference voltage according to a phase difference between the input RF signal and the output RF signal; and
    a processing unit configured to generate the digital control signal according to a voltage difference between the phase difference voltage and a reference voltage according to the set phase.

3.  The RF phase shifter according to claim 2,

    wherein the digital phase shifter comprises a digital variable reactance element configured to digitally vary reactance,
    wherein the digital variable reactance element comprises a plurality of digital capacitors and a plurality of digital inductors,
    wherein the plurality of digital capacitors and the plurality of digital inductors are connected in series or in parallel,
    wherein each of the plurality of digital capacitors comprises a capacitor and a first digital switch connected in series or in parallel, and the first digital switch can be switched between two states of an on state and an off state, and
    wherein each of the plurality of digital inductors comprises an inductor and a second digital switch connected in series or in parallel, and the second digital switch can be switched between two states of an on state and an off state.

4.  The RF phase shifter according to any one of claims 1 to 3, wherein the processing unit integrates a difference voltage between the phase difference voltage and the reference voltage.

# FIG. 1

100(100A)

RF_OUT

V_Phase ref

120

130(130A)

110(110A)

| PHASE DETECTOR | V_Δphase | PROCESSING UNIT | V_control | PHASE SHIFTER |

RF_IN

## FIG. 2

# FIG. 3

# FIG. 4

RF_IN

11

RF_OUT

10

Z0, $\lambda$/4

13

Z0/$\sqrt{2}$, $\lambda$/4

14

Z0/$\sqrt{2}$, $\lambda$/4

12

13_OUT

Z0, $\lambda$/4

14_OUT

1(1A,1B)

1(1A,1B)

# FIG. 5

RF_IN

11

10

RF_OUT

Z0, $\lambda$ /4

1(1A,1B)

1(1A,1B)

# FIG. 6

# FIG. 7

EP 4 607 693 A1

# FIG. 8

EP 4 607 693 A1

## INTERNATIONAL SEARCH REPORT

| International application No. |
| --- |
| **PCT/JP2023/033011** |

| A. | CLASSIFICATION OF SUBJECT MATTER |
| --- | --- |

*H01P 1/18*(2006.01)i; *H03H 7/18*(2006.01)i; *H03H 11/16*(2006.01)i
FI: H01P1/18; H03H7/18; H03H11/16

According to International Patent Classification (IPC) or to both national classification and IPC

| B. | FIELDS SEARCHED |
| --- | --- |

Minimum documentation searched (classification system followed by classification symbols)

H01P1/18; H03H7/18; H03H11/16

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| Y | JP 2014-192807 A (MITSUBISHI ELECTRIC CORP.) 06 October 2014 (2014-10-06) fig. 4 | 1, 2, 4 |
| A | | 3 |
| Y | JP 2008-078995 A (NEC ELECTRONICS CORP.) 03 April 2008 (2008-04-03) paragraphs [0039]-[0048], fig. 3 | 1, 2, 4 |
| A | | 3 |
| Y | JP 9-074325 A (NIPPON TELEGR. & TELEPH. CORP.) 18 March 1997 (1997-03-18) paragraphs [0001], [0044]-[0046], fig. 5 | 1-4 |
| Y | JP 2006-254005 A (YOKOGAWA ELECTRIC CORP.) 21 September 2006 (2006-09-21) paragraphs [0018]-[0029], fig. 1-6 | 1-4 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **19 October 2023** | **07 November 2023** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

INTERNATIONAL SEARCH REPORT

Information on patent family members

International application No.

**PCT/JP2023/033011**

| Patent document cited in search report | | | Publication date (day/month/year) | Patent family member(s) | Publication date (day/month/year) |
|---|---|---|---|---|---|
| JP | 2014-192807 | A | 06 October 2014 | (Family: none) | |
| JP | 2008-078995 | A | 03 April 2008 | US 2008/0088351 A1 paragraphs [0060]-[0069], fig. 1 | |
| JP | 9-074325 | A | 18 March 1997 | (Family: none) | |
| JP | 2006-254005 | A | 21 September 2006 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H09074325 A